(19) Europäisches Patentamt

European Patent Office

Office européen des brevets

(11) EP 0 795 896 A2

## (12) EUROPEAN PATENT APPLICATION

(43) Date of publication:
17.09.1997 Bulletin 1997/38

(51) Int Cl.⁶: **H01L 21/311, C04B 41/53**

(21) Application number: 97400562.1

(22) Date of filing: 13.03.1997

(84) Designated Contracting States:
DE FR GB

(30) Priority: 15.03.1996 JP 59696/96

(71) Applicants:
• ROHM Co., Ltd.
Kyoto-shi Kyoto 651 (JP)
• PLASMA SYSTEM CORPORATION
Kunitachi-shi, Tokyo (JP)

(72) Inventors:
• Kamisawa, Akira, c/o Rohm Co., Ltd.
Kyoto-shi, Kyoto (JP)
• Nakamura, Takashi, c/o Rohm Co., Ltd.
Kyoto-shi, Kyoto (JP)
• Kaneda, Kenji
Kunitachi-shi, Tokyo (JP)

(74) Representative: Boulinguiez, Didier
Cabinet Plasseraud
84, rue d'Amsterdam
75440 Paris Cedex 09 (FR)

## (54) Dry etching method

(57) A dry etching method is suitable for fabricating ferroelectric RAMs, a non-volatile memory, having a central core structure of PZT (a strong dielectric material) sandwiched between two electrodes (Ir/IrO₂). The method is applicable to dry etching of a monolayer or laminated structure of a combination of ferroelectric films such as PZT-based, Sr-based, or Bi-based film as well as electrode structures of Ir or Pt/Ti group materials.

The method utilizes a gaseous mixture of chloride-based gases such as $BCl_3$ and $Cl_2$, or $SiCl_4$, or fluoride-based gases such as $CF_4$, or $C_2F_6$ or a gaseous mixture of chloride- and fluoride-based gases, or bromide-based gases such as HBr. The method produces cavities having a high aspect ratio, free from products of reaction which are usually deposited on the cavity surfaces produced by the conventional dry etchants.

**Description**

BACKGROUND OF THE INVENTION

Field of the Invention

The present invention relates to a method for dry etching of various film structures used for making memory devices, in particular, floating-gate ferroelectric RAMs. Some examples of such film structures include ferroelectric materials such as lead zirco-titanate, strontium- or bismuth-based films, and electrode materials such as iridium or platinum/ titanium group materials in a monolayer or laminated structure.

Description of the Related Art

In recent years, intensive research activities have been directed at developing ferroelectric RAMs which is a type of non-volatile memory. Ferroelectric RAM owes its non-volatility to the use of memory devices made of a strongly dielectric material. In contrast to flash memory devices which are ROM (Read Only Memory), ferroelectric memory devices are RAM (Random Access Memory), that is, ferroelectric RAM offers advantages such as its ability to freely access each bit and superior response speed.

Especially, the ferroelectric RAM using floating gate is configured as a single transistor memory cell having a core structure of lead zirco-titanate $(Pb(Zr_x \cdot Ti_{1-x})O_3$, (abbreviated to PZT hereinbelow) sandwiched between electrodes of iridium/iridium dioxide film (abbreviated to $Ir/IrO_2$ hereinbelow). Adopting this construction has enabled to prevent diffusion and reaction of lead in PZT to lead to degradation of strong dielectric properties, thereby achieving a quantum increase in its rewriting capacity.

However, in manufacturing such floating gate ferroelectric RAMs, the industry had no practical experience in photoresist masking and continuous dry etching of such laminated film structures as $Ir/IrO_2/PZT/Ir/IrO_2$.

Regarding monolayer PZT structures used in various ferroelectric devices, a dry etching method using a gaseous mixture of $SF_6$ and $CHF_3$ has already been proposed. However, this method presents the following problems.

(1) It is only possible to achieve etching rate of less than 50 nm/min, so that the productivity is low.
(2) Deposit are formed on the etched surfaces, caused by the S component in $SF_6$.
(3) Etching selectivity against photoresist material is small, and anisotropic profile could not be produced.

In spite of such problems, there has been no investigation of other alternative gaseous etchants.

There has also been some parallel investigations of dry etching of $Ir/IrO_2$ film structures containing no PZT, without coming to any satisfactory conclusion.

This type of devices may also be made from, for example, strontium (Sr) based films such as $SrTiO_3$, bismuth (Bi) based films such as Y1 (oxide mixture of Sr, Bi, Ta) for ferroelectric devices, and from platinum/titanium based films (referred to as Pt/Ti hereinbelow) for electrode structure. However, conventional semiconductor manufacturing technologies have not had extensive experience with such materials, and the present situation is that there is no practical method of dry etching such materials.

SUMMARY OF THE INVENTION

It is an objective of the present invention to provide a dry etching method for a monolayer film structure or a laminated film structure of combination of ferroelectric materials such as PZT, Sr-, or Bi-based material, and electrode structures based on Ir and Pt/Ti group materials.

The object has been achieved in a method in which the gaseous etchant is either chloride-based gases such as $BCl_3/Cl_2$ or $SiCl_4$, fluoride-based gases such as $CF_4$, $C_2F_6$, a mixture of chloride-based and fluoride-based gases such as $BCl_3$, $Cl_2$ and $SF_6$, or bromide-based gases such as HBr. The method enables dry etching of a monolayer film structure or a laminated film structure made of a combination of materials typically represented by lead zirco-titanate based material, strontium-based material, bismuth-based material, which exhibit ferroelectric properties, and by iridium group and a platinum/titanium group materials suitable for forming electrodes.

BRIEF DESCRIPTION OF THE DRAWINGS

Figure 1 is a schematic cross sectional view of a PZT film fabricated with a first embodiment of the dry etching method of the present invention.

Figure 2 is a schematic cross sectional view of another PZT film fabricated with a conventional dry etching method.

Figure 3 is a schematic cross sectional view of a laminated PZT fabricated with a second embodiment of the dry etching method of the present invention.

DESCRIPTION OF THE PREFERRED EMBODIMENTS

A first embodiment of the method will be presented below.

The first embodiment relates to a method of etching of a monolayer film structure of PZT. This is an example of a structure fabricated using photoresist masking in a reactive ion etching (referred to as RIE) apparatus of a parallel plate type.

It was decided to use a gaseous mixture of $BCl_3$ and $Cl_2$ (a chloride group gas) as the etchant, and operating the RIE apparatus under a set of conditions, for example: RF frequency of 13.56 MHz, RF power of 800 W, a pressure of 10~20 mTorr, pedestal temperature of 10 °C, electrode gap of 30-80 mm, a ratio of flow rates of $BCl_3/Cl_2$ at 30 sccm/ 30 sccm.

The chemical reaction taking place during the etching process is as follows:

$$BCl_3 + Cl_2 + PZT(Pb(Zr,Ti)O_3) + C_xH_yO_z$$

$$\rightarrow PbCl_4 + ZrCl_4 + TiCl_4 + CO + H_2O + BCl_x + \cdots \tag{1}$$

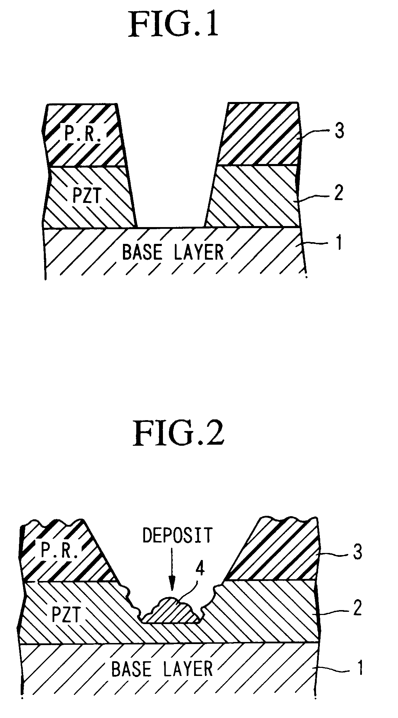

Figures 1 and 2 contrast the shapes of the fabricated cavities produced by the present method and by the conventional method, respectively. The film structure produced by the present process, shown in Figure 1, is comprised of a base layer 1, a PZT film 2, and a photoresist film 3.

The conventional process, using a mixture of gases SF6 and CHF3, produced deposit particles 4 on the PZT film 2, caused by the sulphur constituents in the etchant, as illustrated in Figure 2. In contrast, the reaction products produced in the present process are $PbCl_4$, $ZrCl_4$ and $TiCl_4$ as shown in equation (1), and, because all of the reaction products have relatively high vapor pressures, no unwanted deposit particles were formed on the etched surface as illustrated in Figure 1.

It was found that etching gases other than $BCl_3$, and $Cl_2$ can also be used successfully, for example, a mixture of chloride group gases such as $SiCl_4$, fluoride group gases such as $C_2F_6$ and bromide group gases such as HBr. When using HBr gas, for instance, a volatile reaction product PbBr is again formed as in the case represented by equation (1).

A second embodiment will be presented next. This is an example of dry etching a laminated film structure represented by $Ir/IrO_2/PZT/Ir/IrO_2$.

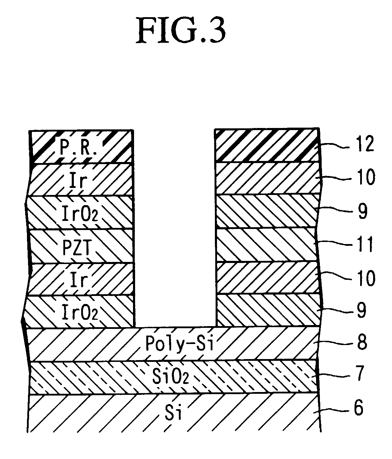

Figure 3 is a schematic drawing of an example of a cavity fabricated in a laminated film structure. The laminated film structure comprises successive layers of: a $SiO_2$ film 7 serving as gate oxide layer formed on a silicon substrate base 6; followed by a polysilicon film 8 serving as a floating gate layer; followed by successive layers of $IrO_2$ film 9/Ir film 10 (electrodes)/ PZT film 11 (ferroelectric layer)/$IrO_2$ film 9/Ir film 10 (control gates).

Etching process was carried out in the parallel plates RIE apparatus using a gaseous mixture of $BCl_3$ and $Cl_2$ and continuously etching the laminated film structure (i.e. $Ir/IrO_2/PZT/Ir/IrO_2$) through a photoresist masking 12, as shown in Figure 3. The conditions for dry etching were the same as those in the first embodiment.

In this etching process also, it was possible to avoid the formation of deposit particles on the etched surface because of the formation of volatile reaction products through the use of $BCl_3$ and $Cl_2$. This process was also able to perform anisotropic etching.

Next, a third embodiment will be presented.

This embodiment relates to dry etching of a structure comprising $Ir/IrO_2$ films.

Etching trials using a photoresist making on $Ir/IrO_2$ films were carried out using the parallel plates RIE apparatus in two kinds of gaseous mixtures. First mixture contained $Cl_2$ and $BCl_3$ while the second mixture contained a suitable amount of $SF_6$ added to the $Cl_2/BCl_3$ mixture. The conditions for dry etching were the same as those in the first embodiment.

There has not been any prior report on dry etching of $Ir/IrO_2$ but it was found through these trials that dry etching was possible using the first gas mixture. However, it was also found that, during the step of removing the photoresist masking, Ir particles were redeposited on the side walls of the masking film to produce a deposit (known as rabbit ears), and this deposit presented a problem that it could not be removed by oxygen plasma processing to remove the photoresist masking.

Etching trials using the second gas mixture demonstrated that a reaction product $IrF_6$ is produced during the dry etching process, because of the presence of $SF_6$ in the second gas mixture. The volatile $IrF_6$ does not adhere to the photoresist masking, therefore it is possible to perform dry etching while preventing the problem of rabbit ear formation.

When the amount of addition of $SF_6$ was too low, rabbit ear formation took place, and when the amount was excessive, the masking film was etched away rapidly because the fluoride group gases readily attacked the photoresist material, and the difference in the etching rates on masking film and on the device structure resulted in a cavity having a slanted wall profile.

It should be noted that, although $SF_6$ was used in this embodiment as an additive gas, other similar type gases such as $C_2F_6$ produced the same result.

It should also be noted that the film structures which can be dry etched using the procedure disclosed are not limited to the materials and film structures mentioned in the foregoing embodiments. Other possibilities include monolayer or laminated film structures of single material or a combination of ferroelectric materials, such as PZT-based films including doped PZT, for example, PLZT $((Pb, La)(Zr, Ti)O_3)$, other lead oxide-based materials such as PTO $(PbTiO_3)$, strontium-based materials such as $SrTiO_3$, bismuth-based materials, electrode films such as Pt/Ti group films. Combinations of primary candidates for film materials and etching gases are summarized in Table 1.

Table 1

| | Etching Gas | Chloride-based Etchant | | Fluoride-based Etchant | | Chloride + Fluoride | Bromide Etchant |
|---|---|---|---|---|---|---|---|
| Film Material | | $BCl_3+Cl_2$ | $SiCl_4$ | $C_2F_6$ | $CF_4$ | $BCl_3+Cl_2+SF_6$ | HBr |
| PZT-based | PZT | ○ | ○ | ○ | ○ | ○ | ○ |
| | PLZT | ○ | ○ | ○ | ○ | ○ | Δ |
| Sr-based | $SrTiO_3$ | ○ | Δ | Δ | X | Δ | ○ |
| Bi-based | Y1 | ○ | ○ | Δ | Δ | ○ | ○ |
| Ir-group | $Ir/IrO_2$ | Δ | Δ | Δ | Δ | ○ | ○ |
| Pt/Ti-group | Pt/Ti | ○ | ○ | X | X | Δ | ○ |

In Table 1, a circle indicates a combination of etching film and etching gases which is practical, a triangle indicates a combination of etching film and etching gases which is possible but presents some problems in practice (for example, etching rate is slow, formation of deposits etc.) and a cross indicates a combination which is not workable. The present invention has demonstrated by experimental trials that a judicious choice of film material and etching gases enables dry etching to be carried out on many useful film materials as indicated partially in Table 1. It is important to recognize the basic principle that partial pressures of the reaction products constitute an important consideration in selecting a type of gas to be used in dry etching processes.

**Claims**

1. A method for dry etching a monolayer structure of a film forming material or a laminated structure of a combination of film forming materials which is characterized by having the steps of:

   placing a film structure to be dry etched in a reactor vessel;
   admitting a gaseous etchant into said reactor vessel at a reduced pressure;
   performing dry etching to produce a cavity; and
   preparing an etched device for further processing;

   wherein said gaseous etchant is a chloride-based gas, and said film forming material is selected from a group consisting of a lead zirco-titanate based material, a strontium-based material, a bismuth-based material, suitable for exhibiting ferroelectric properties, an iridium group material and a platinum/titanium group material suitable for forming electrodes.

2. A method as claimed in claim 1, wherein said chloride-based gas includes a gaseous mixture of $BCl_3$ and $Cl_2$ or gaseous $SiCl_4$.

3. A method for dry etching a monolayer structure of a film forming material or a laminated structure of a combination of film forming materials which is characterized by having the steps of:

placing a film structure to be dry etched in a reactor vessel;
admitting a gaseous etchant into said reactor vessel at a reduced pressure;
performing dry etching to produce a cavity; and
preparing an etched material for further processing;

wherein said gaseous etchant is a fluoride-based gas, and said film forming material is selected from a group consisting of a lead zirco-titanate based material, a strontium-based material, a bismuth-based material, suitable for exhibiting ferroelectric properties, an iridium group material and a platinum/titanium group material suitable for forming electrodes.

4. A method as claimed in claim 3, wherein said fluoride-based gas includes $CF_4$ or $C_2F_6$.

5. A method for dry etching a monolayer structure of a film forming material or a laminated structure of a combination of film forming materials which is characterized by having the steps of:

placing a film structure to be dry etched in a reactor vessel;
admitting a gaseous etchant into said reactor vessel at a reduced pressure;
performing dry etching to produce a cavity; and
preparing an etched material for further processing;

wherein said gaseous etchant is a mixture of a chloride-based gas and a fluoride-based gas, and said film forming material is selected from a group consisting of a lead zirco-titanate based material, a strontium-based material, a bismuth-based material, suitable for exhibiting ferroelectric properties, an iridium group material and a platinum/titanium group material suitable for forming electrodes.

6. A method as claimed in claim 5, wherein said chloride-based gas includes a gaseous mixture of $BCl_3$ and $Cl_2$, or gaseous $SiCl_4$, and said fluoride-based gas includes $CF_4$, or $C_2F_6$.

7. A method for dry etching a monolayer structure of a film forming material or a laminated structure of a film forming material which is characterized by having the steps of:

placing a film structure to be dry etched in a reactor vessel;
admitting a gaseous etchant into said reactor vessel at a reduced pressure;
performing dry etching to produce a cavity; and
preparing an etched material for further processing;

wherein said gaseous etchant is a bromide-based gas, and said film forming material is selected from a group consisting of a lead zirco-titanate based material, a strontium-based material, a bismuth-based material, suitable for exhibiting ferroelectric properties, an iridium group material and a platinum/titanium group material suitable for forming electrodes.

8. A method as claimed in claim 7, wherein said bromide-based gas includes HBr.

# FIG.1

P.R.

PZT

BASE LAYER

3

2

1

# FIG.2

P.R.

DEPOSIT

4

PZT

BASE LAYER

3

2

1

# FIG.3

P.R. — 12
Ir — 10
IrO$_2$ — 9
PZT — 11
Ir — 10
IrO$_2$ — 9
Poly-Si — 8
SiO$_2$ — 7
Si — 6